# EUROPEAN PATENT APPLICATION

(11) **EP 4 830 844 A1**
(43) Date of publication of application: **28.10.2026**
(21) Application number: 25208293.8
(22) Date of filing: 13.10.2025
(51) Int. Cl.: B08B 9/027, B08B 17/00, F16L 55/07, F16L 55/24, B01D 45/00, B01D 45/18

(54) **PIPE DUST COLLECTION DEVICE**

(30) Priority: 21.04.2025 TW 114114901
(71) Applicant: Rayzher Industrial Co., Ltd., Zhubei City, Hsinchu 302054 (TW)
(72) Inventor: WU, Kuen-Yi, 302054 Zhubei City, Hsinchu County (TW); TSAI, Yung-Chin, 302054 Zhubei City, Hsinchu County (TW); CHOU, Ku-Hua, 302054 Zhubei City, Hsinchu County (TW)
(74) Representative: Prinz & Partner mbB

(57) **Abstract**

A pipe dust collection device (Z) includes a device body (1), a dust collection module (2) and at least one cleaning module (3). The device body (1) has an accommodation space (10) and a plurality of openings communicated with the accommodation space (10). The dust collection module (2) has a first driving element (20) connected to a movable element (21) and pass through the device body (1). The movable element (21) has a plurality of communication chambers (210). The movable element (21) is configured to perform a rotational motion or a displacement motion in the accommodation space (10) to change the positions of the communication chambers (210). One of the communication chambers (210) is configured to connect to two of the openings, and another one of the communication chambers (210) is configured to connect to at least another one of the openings. The at least one cleaning module (3) is configured to remove objects from the another communication chamber (210).

## Description

### FIELD OF THE INVENTION

The present invention relates to a pipe dust collecting device, and more particularly to a pipe dust collection device having the function of solving dust accumulation and dust deposition.

### BACKGROUND OF THE INVENTION

Regarding the particle dust treatment system for exhaust gas (waste gas) in the high-tech manufacturing industry, many exhaust gas purification processes require the collection of fine dust. Currently, semiconductor process equipment can use local scrubbers to remove fine dust. When dusty exhaust gas is transported in the pipeline, the dust in the exhaust gas will accumulate on the pipe wall due to the long-term transportation of dusty exhaust gas, causing the pipeline to be blocked. Therefore, the current semiconductor processing equipment can use a plurality of heating bands to prevent dust from clumping and adhering to the pipe walls and being carried away by the exhaust gas.

However, using heating tapes not only increases energy consumption, but also does not completely eliminate the need for cleaning the pipes. Furthermore, when the pipeline is used for a long time, it is necessary to stop the machine for pipeline replacement or pipeline cleaning to maintain the original fluid flow.

### SUMMARY OF THE INVENTION

In response to the above-referenced technical inadequacy, the present invention provides a pipe dust collection device.

In order to solve the above-mentioned problems, one of the technical aspects adopted by the present invention is to provide a pipe dust collection device, which includes a device body, a dust collection module and at least one cleaning module. The device body has an accommodation space and a plurality of openings communicated with the accommodation space. The dust collection module is movably disposed in the accommodation space, in which the dust collection module includes a first driving element and a movable element, the first driving element is connected to the movable element and passing through the device body, the movable element has a plurality of communication chambers, the movable element is configured to move or rotate within the accommodation space to change the positions of the communication chambers, the communication chambers are adjacent to each other and independent of each other, one of the communication chambers is configured to communicate with two of the openings, and another one of the communication chambers is configured to communicate with at least another one of the openings. The at least one cleaning module is movably disposed in the device body and corresponding to the another communication chamber, in which the at least one cleaning module is configured to remove objects from the another communication chamber.

One of the beneficial effects of the present invention is that the pipe dust collecting device provided by the present invention can solve the problem of dust accumulation (or dust deposition) and achieve the effect of dust collection at the same time without stopping the process equipment through the above technical solution.

These and other aspects of the present invention will become apparent from the following description of the embodiment taken in conjunction with the following drawings and their captions, although variations and modifications therein may be effected without departing from the spirit and scope of the novel concepts of the invention.

### BRIEF DESCRIPTION OF THE DRAWINGS

The described embodiments may be better understood by reference to the following description and the accompanying drawings, in which:
FIG. 1 is a partial schematic cross-sectional view of a pipe dust collection device in use according to a first embodiment of the present invention;
FIG. 2 is a partial schematic cross-sectional view of the pipe dust collection device using a movable element according to the first embodiment of the present invention;
FIG. 3 is a lateral schematic cross-sectional view of the pipe dust collection device using a cleaning module according to a second embodiment of the present invention;
FIG. 4 is a partial schematic cross-sectional view of another pipe dust collection device according to the second embodiment of the present invention;
FIG. 5 is a partial schematic cross-sectional view of yet another pipe dust collection device according to the second embodiment of the present invention;
FIG. 6 is a first schematic cross-sectional view of the pipe dust collection device according to the second embodiment of the present invention, corresponding to FIG. 5;
FIG. 7 is a second schematic cross-sectional view of the pipe dust collection device according to the second embodiment of the present invention, corresponding to FIG. 5;
FIG. 8 is a partial schematic cross-sectional view of yet another pipe dust collection device according to the second embodiment of the present invention;
FIG. 9 is a schematic cross-sectional view of the pipe dust collection device according to the second embodiment of the present invention, corresponding to FIG. 8; and
FIG. 10 is an exploded schematic cross-sectional view of yet another pipe dust collection device of the second embodiment of the present invention.

### DETAILED DESCRIPTION OF THE EXEMPLARY EMBODIMENTS

The present invention is more particularly described in the following embodiments and examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present invention.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present invention or of any exemplified term. Likewise, the present invention is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

### [First Embodiment]

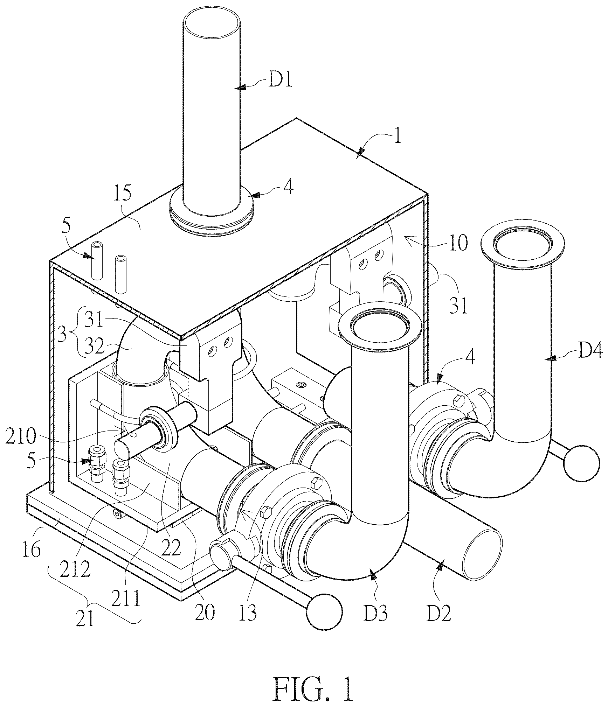

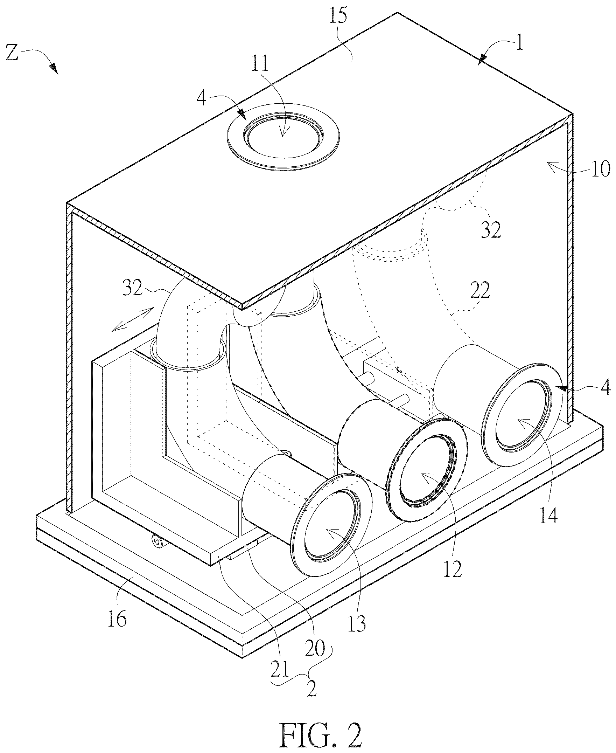

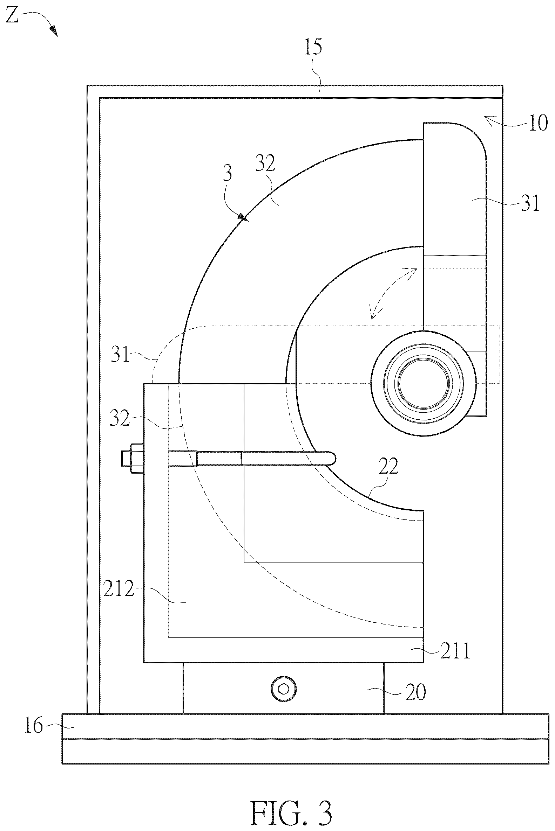

Referring to FIG. 1 to FIG. 3, a first embodiment of the present invention provides a pipe dust collection device Z (or a pipe dust collecting device, or a dust collector for pipe), which may include a device body 1, a dust collection module 2 (or a dust collecting module), and at least one cleaning module 3.

Referring to FIG. 1 to FIG. 3, the device body 1 may have an accommodation space 10 (or a receiving space) and a plurality of openings (such as a first opening 11, a second opening 12, a third opening 13, and a fourth opening 14 described below), and the openings can be communicated with the accommodation space 10. For example, the device body 1 may be a hollow housing structure, and the device body 1 can be divided into an upper cover element 15 and a lower seat element 16. The upper cover element 15 may be a three-dimensional structure having a semicircular, cylindrical, square, or other geometric shape, and the lower seat element 16 may be a plate-like structure, but the present invention is not limited thereto. The upper cover element 15 is detachably connected to the lower seat element 16, the accommodation space 10 can be defined between the upper cover element 15 and the lower seat element 16, and the openings may be located on at least one of the upper cover element 15 and the lower seat element 16. That is to say, the upper cover element 15 may have a plurality of openings, and the lower seat element 16 may have at least one opening or no openings.

More particularly, referring to FIG. 1 to FIG. 3, the openings may include a first opening 11, a second opening 12, a third opening 13, and a fourth opening 14. The first opening 11, the second opening 12, the third opening 13, and the fourth opening 14 may be located on the upper cover element 15, but the present invention is not limited thereto. In actual implementation of the present invention, the arrangement of the openings may be determined by the manufacturer or user's requirements. Furthermore, the first opening 11 can be configured to connect to a first external device D1, and the second opening 12 can be configured to connect to a second external device D2. For example, the first external device D1 and the second external device D2 can be a turbo pump, a dry pump, a local scrubber (or a wet scrubber), a combustion-type exhaust gas removal device, a plasma-type exhaust gas removal device, or a central scrubber (such as a wet scrubber) in semiconductor equipment, but the present invention is not limited thereto. The third opening 13 can be configured to connect to a first cleaning device D3, and the fourth opening 14 can be configured to connect to a second cleaning device D4. For example, the first cleaning device D3 and the second cleaning device D4 can be dust collection equipment for collecting dust, but the present invention is not limited thereto.

More particularly, referring to FIG. 1 to FIG. 3, the dust collection module 2 of the present invention can be movably disposed within the accommodation space 10. The dust collection module 2 may include a first driving element 20 and a movable element 21. The first driving element 20 can be connected to the movable element 21 and disposed on the device body 1. The movable element 21 may have a plurality of communication chambers 210. The movable element 21 can be configured to move within the accommodation space 10 to change the positions of the communication chambers 210. The communication chambers 210 can be adjacent to each other and independent of each other. One communication chamber 210 can be configured to connect to two of the openings, and another communication chamber 210 can be configured to connect to at least another one of the openings.

For example, the dust collection module 2 can be made of metal or plastic. The first driving element 20 can be a lead screw displacement module, a linear slide module, or another type of sliding component. One end of the first driving element 20 can movably pass through the main body of the device body 1. The first driving element 20 can be located at the bottom of the movable element 21. The movable element 21 may include a main body 211 and a plurality of blocking portions 212. The first driving element 20 may be connected to the main body 211 and correspondingly disposed between the communication chambers 210. The blocking portions 212 can be connected to the main body 211 at intervals (or the blocking portions 212 can be spaced apart from each other to connect to the main body 211) to separate the communication chambers 210. The blocking portion 212 may be a block-shaped or plate-shaped structure, and the communication chambers 210 may be arranged in a straight line, but the present invention is not limited thereto. One of the communication chambers 210 may be configured to connect to the first opening 11 and the second opening 12, and another one of the communication chambers 210 may be configured to connect to the third opening 13, or connect to the third opening 13 and the fourth opening 14.

More particularly, the movable element 21 may further include a base portion 213, and the base portion 213 may be connected to the main body 211 and the blocking portions 212. The base portion 213, the main body 211, and the blocking portions 212 may be a single component, but the present invention is not limited thereto. In actual implementation, the main body 211, the blocking portions 212, and the base portion 213 may also be a multi-piece assembly. The base portion 213, two adjacent blocking portions 212, and the main body 211 can be configured to define one of the communication chambers 210. Furthermore, the dust collection module 2 of the present invention may further include a plurality of transport elements 22 (such as fluid conveying elements), and each transport element 22 may be a hollow structure (such as a bend pipe structure) and disposed in one of the communication chambers 210. The two ends of one transport element 22 may correspond to the first opening 11 and the second opening 12, respectively. One end of another transport element 22 may correspond to the third opening 13, or the two ends of another transport element 22 may correspond to the third opening 13 and the fourth opening 14, respectively. The at least one cleaning module 3 may be configured to remove objects from the transport element 22 corresponding to another communication chamber 210.

Next, referring to FIG. 1 to FIG. 3, the at least one cleaning module 3 can be movably disposed on the device body 1 to correspond to another communication chamber 210, and the at least one cleaning module 3 can be configured to remove objects (such as foreign matter) in another communication chamber 210. For example, the cleaning module 3 of the present invention can be a dust cleaning device that uses water power, air flow, mechanical force, gravity, electricity, magnetism or wind power. In this embodiment, a dust cleaning device using mechanical force is used as an example, but the present invention is not limited thereto. The cleaning module 3 may include a second driving element 31 and a removal element 32. The second driving element 31 can be movably disposed on the device body 1, and the second driving element 31 can be configured to drive the removal element 32 to pass through another communication chamber 210 to remove objects in another communication chamber 210. In addition, a part of the body of the second driving element 31 can be located in the accommodation space 10, and another part of the body of the second driving element 31 can be located outside the device body 1. The removal element 32 can be connected to the second driving element 31 and correspond to another communication chamber 210, and the removal element 32 can be a solid and hard structure.

It should be noted that, in one of the feasible or preferred embodiments, the pipe dust collection device Z further includes a plurality of transport modules 4 (or fluid conveying modules), which are tubular structures. Each transport module 4 is disposed on the device body 1 and corresponds to one of the openings. For example, referring to FIG. 1 to FIG. 3, the transport module 4 can be a tubular component that can be detachably connected to the device body 1 or can be combined with the device body 1 to form a single component, and the transport modules 4 can correspond to the first opening 11, the second opening 12, the third opening 13, and the fourth opening 14. Furthermore, the transport modules 4 can be configured to connect to the first external device D1, the second external device D2, the first cleaning device D3, and the second cleaning device D4 respectively, but the present invention is not limited thereto.

Therefore, when the first driving element 20 is driven to perform a displacement motion, the first driving element 20 can be configured to drive the movable element 21 to horizontally or linearly change the positions of the communication chambers 210 within the accommodation space 10 in a horizontal manner or a linear manner. For example, referring to FIG. 1 to FIG. 3, the pipe dust collection device Z of the present invention can be installed in a delivery pipeline between a plurality of process equipment, such as the delivery pipeline between a first external device D1 and a second external device D2. When a process fluid (such as a gas or liquid) is transported from the first external device D1 to the second external device D2 via a pipeline, the process fluid first flows through the pipe dust collection device Z. That is to say, the process fluid outputted from the first external device D1 can first enter the transport element 22 inside the device body 1 through the first opening 11 (or including one of the transport modules 4), and then the process fluid can be outputted to the delivery pipeline through the second opening 12 (or including one of the transport modules 4) and then transported to the second external device D2 through the delivery pipeline.

After a period of transporting process fluid, the foreign matter in the process fluid may accumulate or settle on the transport element 22, thereby reducing the transporting efficiency of the process fluid and potentially causing blockage. At this point, the first driving element 20 can be driven to move or offset (i.e., linear displacement) the movable element 21, causing another communication chamber 210 to move to a position corresponding to the first opening 11 and the second opening 12. The communication chamber 210 originally corresponding to the first opening 11 and the second opening 12 and having foreign matter accumulated therein can be moved to another position in the accommodation space 10.

Next, the transport element 22 that is initially used and has accumulated foreign matter can be moved to a position corresponding to the third opening 13 or the fourth opening 14. At this point, the operator can operate the second driving element 31 to drive the removal element 32 to pass through the corresponding transport element 22, and use the removal element 32 to push out or discharge the foreign matter from the transport element 22 to the outside of the transport element 22. In addition, the foreign matter pushed out or discharged by the removal element 32 is then transported to the first cleaning device D3 through the third opening 13 (or fourth opening 14, or including one of the transport modules 4), and the first cleaning device D3 can receive the foreign matter, thus completing the cleaning of the communication chamber 210.

Therefore, the pipe dust collecting device Z of the present invention can utilize the above-mentioned technical solution to set up a movable multi-cavity structure (i.e., the dust collection module 2) in the device body 1, and then cooperate with a plurality of openings on the device body 1 to respectively connect to the first external device D1, the second external device D2, the first cleaning device D3, and the second cleaning device D4. When the foreign matter accumulates or becomes blocked in the pipe between the first external device D1 and the second external device D2, the pipe between the first external device D1 and the second external device D2 can be unblocked by immediately switching the communication chamber 210 in the pipe dust collecting device Z (or the communication chamber 210 in the pipe dust collecting device Z can be immediately switched to keep the pipe between the first external device D1 and the second external device D2 in an unobstructed state). As for the transport element 22 that is switched (offset) and is accumulated and blocked by the foreign matter, it can be cleaned by the first cleaning device D3 and the second cleaning device D4. Thus, the present invention does not need to install additional pipe (elbow) heating belts (bands) on the pipeline, and the problem of dust accumulation and dust collection can be solved without stopping the process equipment. Moreover, the pipe (or tube) replacement can be achieved simply and quickly without stopping the process equipment.

### [Second Embodiment]

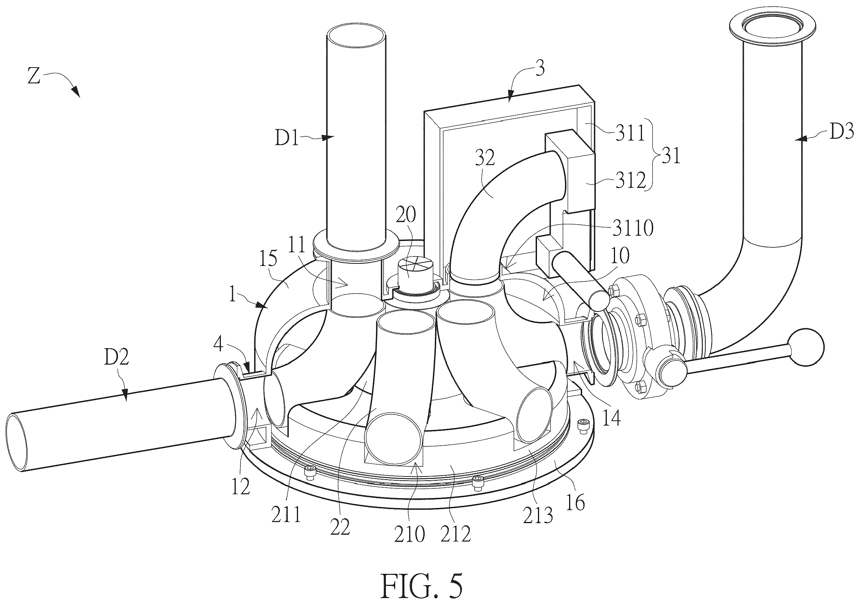

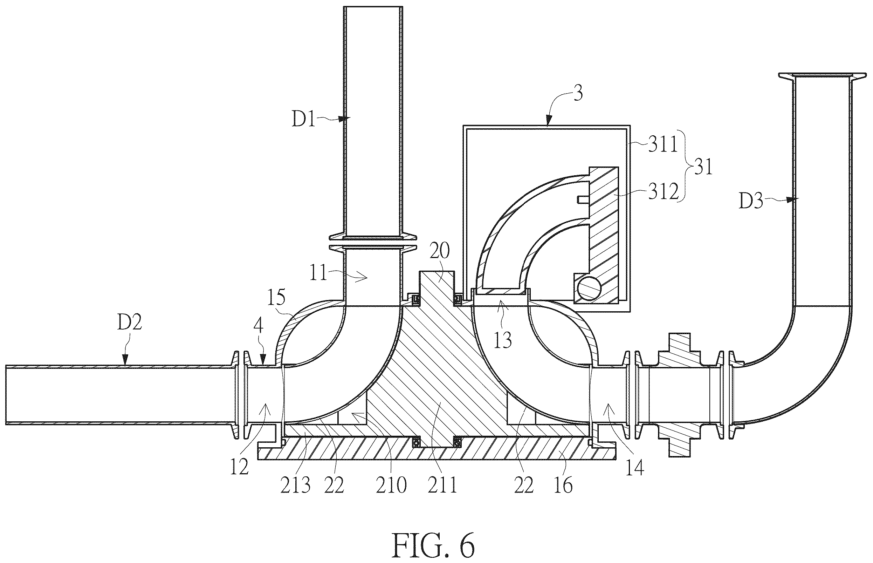

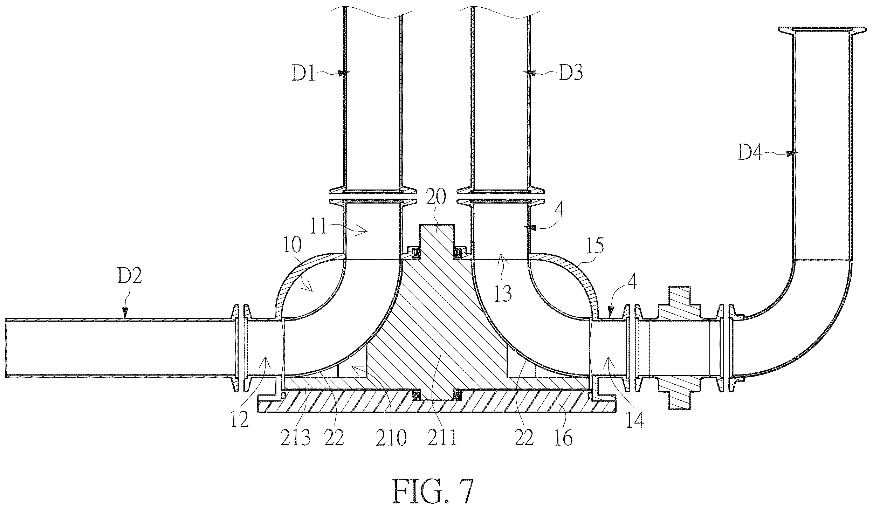

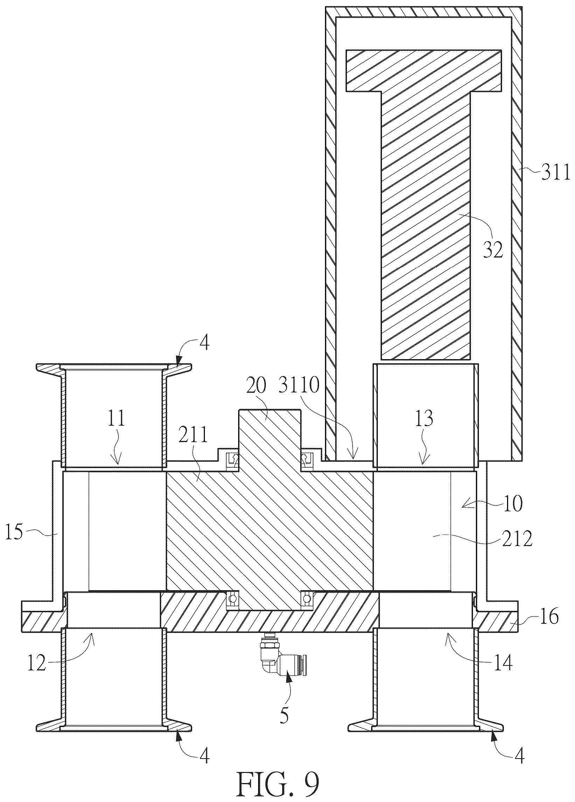

Referring to FIG. 1 to FIG. 3, and FIG. 4 to FIG. 10, the pipe dust collection device Z of this embodiment is substantially similar to the pipe dust collection device Z of the first embodiment. Therefore, the arrangement and operation of the same components will not be further described here. The difference between this embodiment and the first embodiment is as follows: in this embodiment, the first opening 11, the third opening 13, and the fourth opening 14 may be located on the upper cover element 15, and the second opening 12 may be located on the lower seat element 16. Alternatively, the first opening 11, the second opening 12, the third opening 13, and the fourth opening 14 may all be located on the upper cover element 15, but the present invention is not limited thereto. In actual implementation, the opening arrangement of the present invention may be determined by the different requirements of the manufacturer or the user. The first opening 11 and the second opening 12 may be positioned opposite each other (as shown in FIG. 9), or the first opening 11 may be adjacent to the second opening 12 (as shown in FIG. 6 and FIG. 7). The third opening 13 and the fourth opening 14 may be positioned opposite each other (as shown in FIG. 9), or the third opening 13 may be adjacent to the fourth opening 14 (as shown in FIG. 6 and FIG. 7). The first driving element 20 can be a pivot structure movably disposed and passing through the device body 1, or the main body 211 of the movable element 21. The first driving element 20 can be located at the center of the movable element 21 and can be cooperated with the movable element 21 to form a single component, but the present invention is not limited thereto. The movable element 21 can be configured to move or rotate within the accommodation space 10 to change the positions of the communication chambers 210, and the communication chambers 210 can be surroundingly arranged in a circular pattern.

Furthermore, the second driving element 31 may include a fixed element 311 and a linkage element 312 (or a connecting element). The fixed element 311 can be a hollow structure and disposed on the outer surface of the device body 1. The fixed element 311 may have a through opening 3110 that can communicate with one of the openings. The linkage element 312 can be disposed on the fixed element 311 and connected to the removal element 32. The linkage element 312 can be configured to drive the removal element 32 to pass through the through opening 3110 and one of the openings to be disposed inside another communication chamber 210.

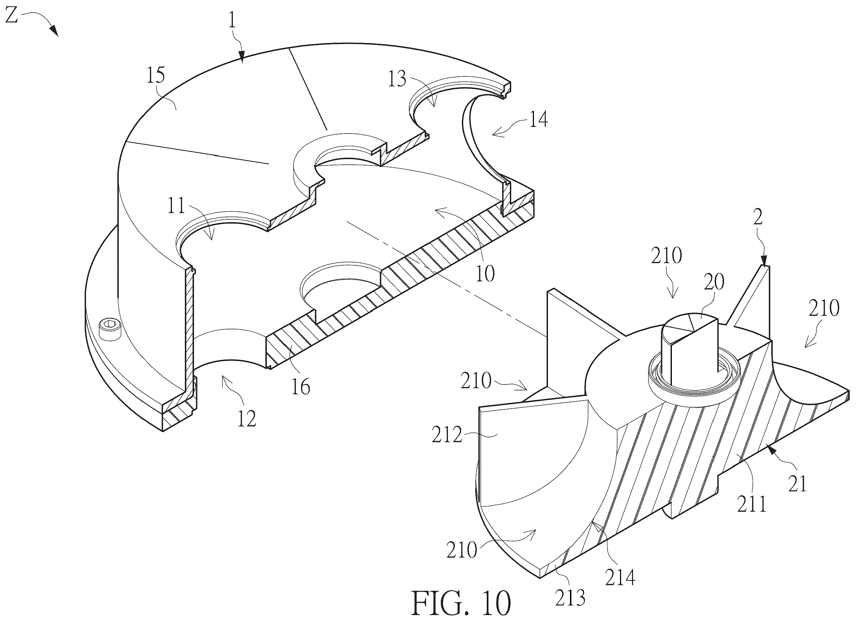

In addition, a top surface of the base 213 of the movable element 21 of the present invention can be connected to a side surface of the main body 211 to form a curved surface 214 or an arcuate surface (as shown in FIG. 10), so that the transport element 22 can be omitted.

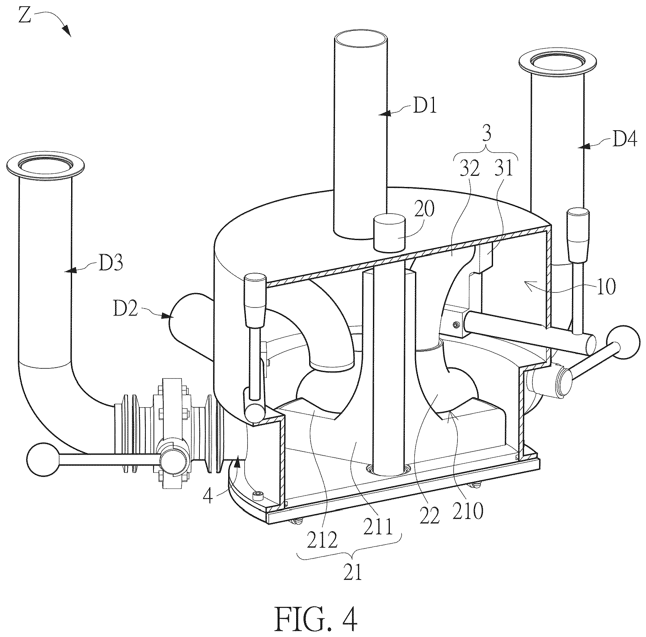

Therefore, when the first driving element 20 is driven to perform a rotational motion, the first driving element 20 can be configured to drive the movable element 21 to rotate so as to rotationally change the position of the communication chambers 210 within the accommodation space 10. For example, referring to FIG. 4 to FIG. 10, when the pipe dust collecting device Z of the present invention is used at a predetermined time, and the foreign matter is accumulated or blocked (clogged) in the pipe (i.e., the transport element 22) between the first external device D1 and the second external device D2, the first driving element 20 can be rotated (i.e., the first driving element 20 being configured as a rotation axis) to drive the movable element 21 in the accommodation space 10 to rotate the transport element 22 that is not accumulated or blocked (clogged) by the foreign matter) to a position between the first external device D1 and the second external device D2, thereby maintaining the unobstructed pipe to be disposed between the first external device D1 and the second external device D2 (that is to say, the pipeline between the first external device D1 and the second external device D2 can be in a smooth fluid-free state).

In addition, as shown in FIG. 7, in another optional embodiments, the cleaning module 3 of the present invention may also be a dust cleaning device that utilizes hydraulic, airflow, gravity, electricity, or magnetism, but the present invention is not limited thereto. Therefore, after the movable element 21 of the dust collection device Z rotates and moves several times, the transport element 22 (or the communication chamber 210) that is initially used and accumulated (clogged) with the foreign matter can be moved to a position corresponding to the third opening 13 and the fourth opening 14. At this time, after a specific fluid (such as gas or liquid containing a cleaning agent, but not limited to such) outputted by the cleaning module 3 enters the transport element 22 inside the device body 1 through the third opening 13 (or including one of the transport modules 4), the specific fluid can remove the foreign matter in the transport element 22 and carry the foreign matter away from the transport element 22 and can then be moved toward the fourth opening 14. Next, the foreign matter can be output from the fourth opening 14 (or including one of the transport modules 4) along with the specific fluid to the first cleaning device D3, and the first cleaning device D3 receives the foreign matter and the specific fluid, thereby completing the operation of cleaning the transport element 22.

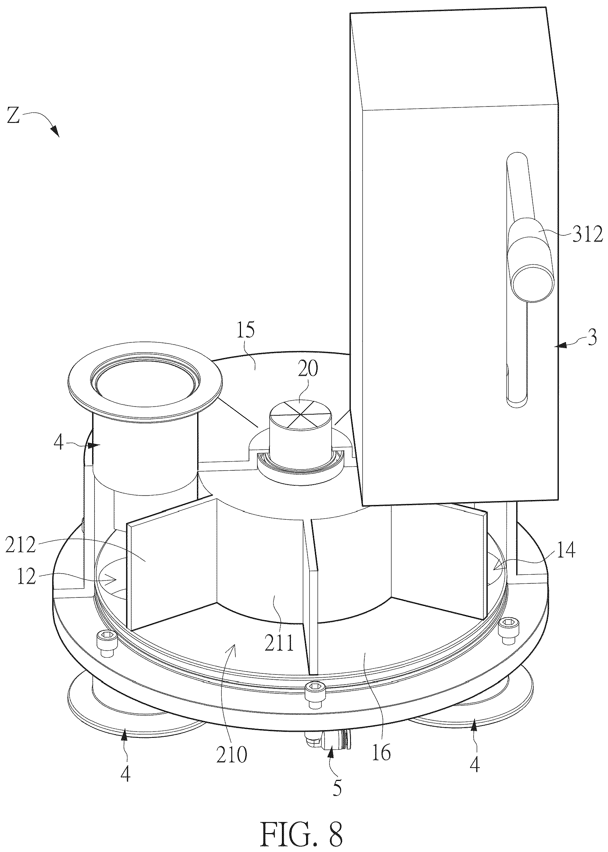

It is worth noting that the pipe dust collection device Z of the present invention further includes a cooling module 5 that can be disposed on the device body 1 or the movable element 21, and the cooling module 5 can be configured to cool the device body 1 or the movable element 21. For example, referring to FIG. 1 and FIG. 8, the cooling module 5 can be a fluid cooling device (such as a water cooling device or an air cooling device), a cooling component (such as a cooling chip), or another type of cooling assembly. Therefore, the pipe dust collection device Z of the present invention can use the cooling module 5 to cool the lower seat element 16 of the device body 1, or the movable element 21 (indirectly cooling the communication chamber 210 and the transport element 22), thereby accelerating the accumulation and deposition of the foreign matter in the communication chamber 210 or the transport element 22, and removing the foreign matter by the cleaning module 3 later.

However, the examples provided in the above embodiments are merely feasible embodiments and are not intended to limit the scope of the present invention.

### [Beneficial Effects of the Embodiments]

One of the beneficial effects of the present invention is that the pipe dust collecting device Z provided by the present invention can solve the problem of dust accumulation (or dust deposition) and achieve the effect of dust collection at the same time without stopping the process equipment through the above technical solution.

More particularly, the pipe dust collecting device Z of the present invention can utilize the above-mentioned technical solution to set up a movable multi-cavity structure (i.e., the dust collection module 2) in the device body 1, and then cooperate with a plurality of openings on the device body 1 to respectively connect to the first external device D1, the second external device D2, the first cleaning device D3, and the second cleaning device D4. When the foreign matter accumulates or becomes blocked in the pipe between the first external device D1 and the second external device D2, the pipe between the first external device D1 and the second external device D2 can be unblocked by immediately switching the communication chamber 210 in the pipe dust collecting device Z (or the communication chamber 210 in the pipe dust collecting device Z can be immediately switched to keep the pipe between the first external device D1 and the second external device D2 in an unobstructed state). As for the transport element 22 that is switched (offset) and is accumulated and blocked by the foreign matter, it can be cleaned by the first cleaning device D3 and the second cleaning device D4. Thus, the present invention does not need to install additional pipe (elbow) heating belts on the pipeline, and the problem of dust accumulation and dust collection can be solved without stopping the process equipment. Moreover, the pipe (or tube) replacement can be achieved simply and quickly without stopping the process equipment.

The foregoing description of the exemplary embodiments of the invention has been presented only for the purposes of illustration and description and is not intended to be exhaustive or to limit the invention to the precise forms disclosed. Many modifications and variations are possible in light of the above teaching.

The embodiments were chosen and described in order to explain the principles of the invention and their practical application so as to enable others skilled in the art to utilize the invention and various embodiments and with various modifications as are suited to the particular use contemplated.

## Claims

1. A pipe dust collection device (Z), **characterized by** comprising:
a device body (1) having an accommodation space (10) and a plurality of openings communicated with the accommodation space (10);
a dust collection module (2) movably disposed in the accommodation space (10), wherein the dust collection module (2) includes a first driving element (20) and a movable element (21), the first driving element (20) is connected to the movable element (21) and passing through the device body (1), the movable element (21) has a plurality of communication chambers (210), the movable element (21) is configured to move or rotate within the accommodation space (10) to change the positions of the communication chambers (210), the communication chambers (210) are adjacent to each other and independent of each other, one of the communication chambers (210) is configured to communicate with two of the openings, and another one of the communication chambers (210) is configured to communicate with at least another one of the openings; and
at least one cleaning module (3) movably disposed in the device body (1) and corresponding to the another communication chamber (210), wherein the at least one cleaning module (3) is configured to remove objects from the another communication chamber (210).

2. The pipe dust collection device (Z) according to claim 1,
wherein the openings include a first opening (11), a second opening (12), a third opening (13), and a fourth opening (14), one of the communication chambers (210) is configured to connect to the first opening (11) and the second opening (12), and the another one of the communication chambers (210) is configured to connect with the third opening (13) or connect to the third opening (13) and the fourth opening (14); and
wherein the first opening (11) is configured to connect to a first external device (D 1 ), the second opening (12) is configured to connect to a second external device (D2), the third opening (13) is configured to connect to a first cleaning device (D3), and the fourth opening (14) is configured to connect to a second cleaning device (D4) or correspond to the at least one cleaning module (3).

3. The pipe dust collection device (Z) according to claim 2,
wherein the dust collection module (2) further includes a plurality of transport elements (22), each of the transport elements (22) is a hollow structure and disposed in one of the communication chambers (210), one of the transport elements (22) corresponds to the first opening (11) and the second opening (12), and another one of the transport elements (22) corresponds to at least one of the third opening (13) and the fourth opening (14); and
wherein the at least one cleaning module (3) is configured to remove objects from the transport element (22) corresponding to the another communication chamber (210).

4. The pipe dust collection device (Z) according to any of the preceding claims, wherein the at least one cleaning module (3) includes a second driving element (31) and a removal element (32), the second driving element (31) is movably disposed on the device body (1), the removal element (32) is connected to the second driving element (31) and corresponding to the another communication chamber (210), the second driving element (31) is configured to drive the removal element (32) to pass through the another communication chamber (210) to remove the objects from the another communication chamber (210).

5. The pipe dust collection device (Z) according to claim 4, wherein the second driving element (31) includes a fixed element (311) and a linkage element (312), the fixed element (311) is disposed on the device body (1) and has a through opening (3110) that is communicated with one of the openings, the linkage element (312) is disposed on the fixed element (311) and connected to the removal element (32), and the linkage element (312) is configured to drive the removal element (32) to pass through the through opening (3110) and one of the openings to be disposed inside the another one of the communication chambers (210).

6. The pipe dust collection device (Z) according to any of the preceding claims,
wherein the communication chambers (210) are arranged in a circular manner or a linear manner;
wherein, when the communication chambers (210) are arranged in the circular manner and the first driving element (20) is driven to perform a rotational motion, the first driving element (20) is configured to drive the movable element (21) to rotationally change the positions of the communication chambers (210) within the accommodation space (10); and
wherein, when the communication chambers (210) are arranged in the linear manner and the first driving element (20) is driven to perform a displacement motion, the first driving element (20) is configured to drive the movable element (21) to horizontally or linearly change the positions of the communication chambers (210) within the accommodation space (10).

7. The pipe dust collection device (Z) according to any of the preceding claims, wherein the movable element (21) includes a main body (211) and a plurality of blocking portions (212), the blocking portions (212) are spaced apart from each other and connected to the main body (211) portion to separate the communication chambers (210), and the first driving element (20) is connected to the main body (211) and correspondingly disposed between the communication chambers (210).

8. The pipe dust collection device (Z) according to claim 7,
wherein the movable element (21) further includes a base portion (213) connected to the main body (211) and the blocking portions (212), and one of the communication chambers (210) is defined by the base portion (213), two of the blocking portions (212), and the main body (211); and
wherein a top surface of the base portion (213) is connected to a side surface of the main body (211) to form a curved surface (214).

9. The pipe dust collection device (Z) according to any of the preceding claims, further comprising a plurality of transport modules (4) each having a tubular structure, wherein the transport modules (4) are disposed on the device body (1) and correspond to one of the openings.

10. The pipe dust collection device (Z) according to any of the preceding claims,
wherein the at least one cleaning module (3) is configured to remove the objects from the another communication chamber (210) by using hydraulic, airflow, mechanical, gravity, electricity or magnetic forces; and
wherein the pipe dust collection device (Z) further comprises a cooling module (5) disposed on the device body (1) or the movable element (21), and the cooling module (5) is configured to cool the device body (1) or the movable element (21).
